# EUROPEAN PATENT APPLICATION

(11) **EP 4 223 862 A1**
(43) Date of publication of application: **09.08.2023**
(21) Application number: 21875272.3
(22) Date of filing: 17.09.2021
(51) Int. Cl.: C11D 1/02, H01L 21/304

(54) **POLISHING AND CLEANING METHOD, CLEANING AGENT, AND POLISHING/CLEANING SET**

(30) Priority: 30.09.2020 JP 2020164596
(71) Applicant: Fujimi Incorporated, Kiyosu-shi, Aichi 452-8502 (JP)
(72) Inventor: HIRAKO, Sachiko, Kiyosu-shi, Aichi 452-8502 (JP); NOGUCHI, Naoto, Kiyosu-shi, Aichi 452-8502 (JP)
(74) Representative: Grünecker Patent- und Rechtsanwälte PartG mbB
(86) International application number: PCT/JP2021/034213
(87) International publication number: WO 2022/070970

(57) **Abstract**

Provided is a method that enables good cleaning of a polished substrate formed of a high-hardness material. Provided is a method of polishing and cleaning a substrate formed of a material having a Vickers hardness of 1500 Hv or more. The method includes: polishing a substrate to be polished using a polishing composition; and cleaning the polished substrate using a cleaner. The polishing composition contains a polishing auxiliary. Furthermore, the cleaner contains a surfactant.

## Description

### [Technical Field]

The present invention relates to a polishing and cleaning method, a cleaner, and a polishing cleaning set, particularly to a method of polishing and cleaning a high-hardness material having a Vickers hardness of 1500 Hv or more; and a cleaner, a polishing cleaning set, and a cleaning method used for the cleaning.

The application claims the priority based on Japanese Patent Application No. 2020-164596 filed on September 30, 2020, the content of which is herein incorporated by reference in its entirety.

### [Background Art]

A substrate formed of diamond, sapphire (aluminum oxide), silicon carbide, boron carbide, tungsten carbide, silicon nitride, titanium nitride, or the like usually has a surface smoothed by polishing (lapping) that is performed by supplying diamond abrasives to a polishing platen. However, lapping with use of diamond abrasives generates a scratch that in turn remains, thus limiting improvement in surface smoothness. To deal with this, an investigation has been made for a polishing process (polishing) that is performed by supplying a polishing slurry with a polishing pad between the polishing pad and a substrate, after or instead of lapping with use of diamond abrasives. The surface of the substrate experienced such polishing is subjected to cleaning for the purpose of removing attachments such as polish residues and polishing components. Examples of a technical literature that discloses cleaning of a substrate after polishing include Patent Documents 1 to 4.

### [Citation List]

### [Patent Literature]

[Patent Document 1] Japanese translation of PCT international application No. 2017-523950
[Patent Document 2] Japanese Patent Application Publication No. 2013-10888
[Patent Document 3] WO2013/088928
[Patent Document 4] Japanese Patent No. 5659152

### [Summary of Invention]

### [Technical Problem]

A substrate formed of the high-hardness material described above is finished by polishing so as to have a high-grade surface. A cleaning process performed after polishing also preferably removes attachments on the surface of a substrate, and achieves a high-quality, clean surface. With regard to cleaning of a substrate formed of a high-hardness material, for example, Patent Document 1 describes that a silicon carbide substrate is cleaned with an ultrasonic cleaning tank using a low-concentration caustic surfactant (9 < pH < 12) mixed with deionized water, for the purpose of removing particles after diamond polishing. However, Patent Document 1 has no disclosure related to polishing with use of a polishing auxiliary. Furthermore, as described above, polishing with use of diamond abrasives has limitation in improving a surface quality, and tends to fail to provide a satisfactory surface quality even after cleaning is performed. Meanwhile, Patent Document 2 discloses use of a cleaner for the purpose of removing wax used for fixing a substrate. However, Patent Document 2 does not describe evaluation using a polished substrate, and investigation for removability of attachments such as polish residues and polishing components.

The present invention was made in view of the foregoing circumstances, and has an object to provide a method that enables good cleaning of a polished substrate formed of a high-hardness material. Another related object is to provide a cleaner and a polishing cleaning set used in the aforementioned method. Further related object is to provide a method of cleaning the substrate described above.

### [Solution to Problem]

The specification provides a method of polishing and cleaning a substrate formed of a material having a Vickers hardness of 1500 Hv or more. The method includes: polishing a substrate to be polished using a polishing composition; and cleaning the polished substrate using a cleaner. The polishing composition contains a non-diamond abrasive and/or a polishing auxiliary. The cleaner also contains a surfactant. According to this method, a substrate formed of a high-hardness material is well-cleaned by performing a polishing step using a polishing composition containing a non-diamond abrasive, followed by a cleaning step using a cleaner containing a surfactant. Use of the cleaner allows production of a substrate having less attachments and higher surface quality.

In some preferable embodiments, the cleaner contains an anionic surfactant as the surfactant. A surfactant that exerts good cleanability for a polished substrate formed of a high-hardness material can be preferably selected among anionic surfactants.

Examples of the surfactant to be preferably used in the technologies disclosed herein include a compound having an oxyalkylene unit.

The surfactant in the cleaner preferably has a concentration of 1% or more by weight. Increase in the concentration of the surfactant can cause more exertion of an additive effect of the surfactant, and preferably exhibition of more cleaning effect.

In some embodiments, a cleaner may contain water in addition to a surfactant. A water-containing cleaner (sometimes a cleaning liquid) can allow a surfactant to exert more effect.

In some preferable embodiments, a substrate formed of a material having a Vickers hardness of 1500 Hv or more is a silicon carbide substrate. An effect by the technologies disclosed herein is preferably exerted in a substrate formed of silicon carbide.

The specification also provides a cleaner used in any of the methods disclosed herein. The cleaner contains a surfactant. The cleaner having the composition described above can exert a good cleaning effect on a polished substrate formed of a high-hardness material.

The specification also provides a polishing cleaning set including a polishing composition and a cleaner. The polishing cleaning set is used in any of the methods disclosed herein. In the polishing cleaning set, the polishing composition contains a non-diamond abrasive and/or a polishing auxiliary. Furthermore, the cleaner contains a surfactant. The polishing cleaning set having such a configuration can be used to polish and clean a substrate formed of a high-hardness material, thereby providing a substrate that has high surface quality and is cleaned to have a clean surface.

The specification also provides a method of cleaning a silicon carbide substrate after polishing with use of a non-diamond abrasive. This cleaning method includes a step of cleaning a silicon carbide substrate using a cleaner. In addition, the cleaner contains a surfactant. Such a cleaning method produces a substrate formed of a high-hardness material having a well-cleaned surface. Preferably, the polishing with use of a non-diamond abrasive is polishing with use of a polishing composition containing a non-diamond abrasive.

The specification also provides a method of cleaning a silicon carbide substrate after polishing with use of a polishing auxiliary. The cleaning method includes a step of cleaning a silicon carbide substrate with use of a cleaner. In addition, the cleaner contains a surfactant. Such a cleaning method produces a substrate formed of a high-hardness material having a well-cleaned surface. The polishing with use of a polishing auxiliary is preferably polishing with use of a polishing composition containing a polishing auxiliary.

The specification also provides a cleaner used in cleaning of a silicon carbide substrate after polishing with use of a non-diamond abrasive. The cleaner contains a surfactant. The cleaner having the composition described above can exert a good cleaning effect on a substrate formed of a high-hardness material after the polishing. Preferably, the polishing with use of a non-diamond abrasive is polishing with use of a polishing composition containing a non-diamond abrasive.

The specification also provides a cleaner used in cleaning of a silicon carbide substrate after polishing with use of a polishing auxiliary. The cleaner contains a surfactant. The cleaner having the composition described above can exert a good cleaning effect on a substrate formed of a high-hardness material after the polishing. Preferably, the polishing with use of a polishing auxiliary is polishing with use of a polishing composition containing a polishing auxiliary.

### [Brief Description of Drawings]

Fig. 1 is an AFM image of the surface of a SiC wafer after cleaning according to Comparative Example 1.
Fig. 2 is an AFM image of the surface of a SiC wafer after cleaning according to Example 1.
Fig. 3 is an AFM image of the surface of a SiC wafer after cleaning according to Example 2.
Fig. 4 is an AFM image of the surface of a SiC wafer after cleaning according to Example 3.
Fig. 5 is an AFM image of the surface of a SiC wafer after cleaning according to Example 4.

### [Description of Embodiments]

Preferred embodiments in the present invention will now be described below. Matters that are other than those particularly mentioned herein but are necessary for implementation of the present invention can be recognized as matters to be designed by those skilled in the art based on conventional technologies in the art. The present invention can be implemented based on contents disclosed herein and common technical knowledge in the art.

### <Substrate>

The technologies disclosed herein encompass a method of cleaning a substrate formed of a material having a Vickers hardness of 1500 Hv or more (also referred to as high-hardness material), and more particularly, a method of cleaning after polishing of a substrate formed of such high-hardness material; therefore, a substrate formed of the high-hardness material represents not only a substrate to be cleaned but also a substrate to be polished. The method disclosed herein provides good cleaning of the surface of a substrate formed of the high-hardness material as described above. The Vickers hardness of a high hardness material is preferably 1800 Hv or more (e.g. 2000 Hv or more, and typically 2200 Hv or more). The maximum Vickers hardness is not particularly limited, and may be about 7000 Hv or less (e.g. 5000 Hv or less, typically 3000 Hv or less). The Vickers hardness herein can be measured based on JIS R 1610:2003. The international standard corresponding to this JIS standard is ISO 14705:2000.

Examples of materials having a Vickers hardness of 1500 Hv or more include diamond, sapphire (aluminum oxide), silicon carbide, boron carbide, tungsten carbide, silicon nitride, and titanium nitride. The method disclosed herein can be preferably applied to cleaning after polishing of a single crystal surface of such a mechanically- and chemically-stable material. In particular, the surface of a substrate to be polished is preferably formed of silicon carbide. A C (carbon) face of a silicon carbide substrate tends to have more difficulty in eliminating polishing waste, polishing component, and the like after polishing, compared to a Si (silicon) face, and the cleaning method disclosed herein is particularly preferred for cleaning such a C face. Moreover, silicon carbide has been expected to be as a semiconductor substrate material having less power loss and good thermal resistance, and thus there is a great practical advantage in improving the surface properties of a silicon carbide, and also in subjecting a polished silicon carbide surface having high surface quality to a cleaning process, and finishing the surface to be a clean surface. The method disclosed herein is particularly preferably applied to a single crystal surface of silicon carbide.

### <Cleaner>

### (Surfactant)

The cleaner disclosed herein is a cleaner used in cleaning a polished substrate formed of a high-hardness material, and is characterized by containing a surfactant. Cleaning with use of a cleaner containing a surfactant can achieve a good cleaning effect for a polished substrate formed of a high-hardness material. Particularly, the cleaning can remove attachments such as particles attached to the surface of a polished substrate formed of a high-hardness material, from the surface of the substrate.

A surfactant used for the cleaner is not particularly limited, and any surfactant that is an anionic, cationic, nonionic, or amphoteric can be used. A surfactant that exerts good cleanability for the surface of a polished substrate formed of a high-hardness material can be preferably selected among anionic surfactants. Alternatively, a nonionic surfactant is preferably used in view of low foamability and ease of pH adjustment. Surfactants can be used singly or in combination of two or more kinds.

Examples of anionic surfactants include sulfonic acid-based compounds such as alkanesulfonic acid salt, alkylbenzene sulfonic acid salt (e.g., nonylbenzene sulfonic acid salt, decylbenzene sulfonic acid salt, and dodecylbenzene sulfonic acid salt), naphthalene sulfonic acid salt, alkyl sulfuric acid salt (e.g., lauryl sulfuric acid salt and octadecyl sulfuric acid salt), polyoxyalkylene sulfuric acid salt, α-olefinsulfonic acid salt, α-sulfo fatty acid salt, α-sulfo fatty acid alkyl ester salt, alkyl sulfosuccinic acid salt, and dialkyl sulfosuccinic acid salt; sulfate compounds such as alkylsulfate salt, alkenylsulfate salt, polyoxyalkylene alkylethersulfate salt (e.g., polyoxyethylene octadecylether sulfuric acid salt, polyoxyethylene laurylether sulfuric acid salt), and polyoxyalkylene alkenylether sulfate salt; carboxylic acid-based compounds such as alkylether carboxylic acid salt, amide ether carboxylic acid salt, sulfosuccinic acid salt, and amino acid-based surfactants; and phosphate compounds such as alkylphosphate salt and alkyletherphosphate salt. In particular, polyoxyalkylene alkylether sulfate salt is preferable. When an anionic surfactant forms a salt, the salt may be, e.g., a metallic salt such as a sodium salt, a potassium salt, a calcium salt, or a magnesium salt, and is preferably a monovalent metal salt; an ammonium salt; or an amine salt. Anionic surfactants can be used singly or in combination of two or more kinds.

Examples of nonionic surfactants include oxyalkylene polymers such as polyethylene glycol, polypropylene glycol, and polytetramethylene glycol; polyoxyalkylene derivatives (e.g., polyoxyalkylene adducts) such as polyoxyethylene alkyl ether, polyoxyethylene alkyl phenyl ether, polyoxyethylene alkylamine, polyoxyethylene fatty acid ester, polyoxyethylene glyceryl ether fatty acid ester, and polyoxyethylene sorbitan fatty acid ester; and a copolymer of a plurality of types of oxyalkylenes (e.g., diblock copolymer, triblock copolymer, random copolymer, and alternate copolymer). Nonionic surfactants can be used singly or in combination of two or more kinds.

Examples of cationic surfactant include amine cationic surfactants such as alkyl amide amine and alkylamine; and quaternary ammonium salt cationic surfactants such as tetraalkyl (1-4 carbons) ammonium salt (e.g., tetramethyl ammonium salt), mono-long-chain alkyl (8-18 carbons) tri-short-chain alkyl (1-2 carbons) ammonium salt (e.g., lauryl trimethyl ammonium salt, palmityl trimethyl ammonium salt, and stearyl trimethyl ammonium salt), and di-long-chain alkyl (8-18 carbons) di-short-chain alkyl (1-2 carbons) ammonium salt. When a cationic surfactant forms a salt, the salt may be, e.g., a halide of chlorine, bromine, iodine, or the like; a hydroxide; or a sulfonate, sulfate, nitrate, or the like with 1-5 carbons. In particular, the salt is preferably selected from quaternary ammonium salt cationic surfactants (preferably mono-long-chain alkyl tri-short-chain alkyl ammonium salt, di-long-chain alkyl di-short-chain alkyl ammonium salt, etc.) Cationic surfactants can be used singly or in combination of two or more kinds.

An amphoteric surfactants is not particularly limited, and examples thereof include amine alkylene oxide surfactants and amine oxide surfactants. These can be used singly or in combination of two or more kinds thereof.

A surfactant (preferably an anionic surfactant) used in some preferable embodiments may be a compound having an oxyalkylene unit, and typically a compound having a polyoxyalkylene structure. The oxyalkylene unit may be formed of a single oxyalkylene group, or may be a repeated structure of two or more oxyalkylene units. Examples of the oxyalkylene unit include an oxyethylene unit (EO) and an oxypropylene unit (PO). In particular, an oxyethylene unit (EO) is preferable. When a surfactant has a plurality of oxyalkylene units, the oxyalkylene units may be the same type (i.e., a single type), or may be formed with including two or more oxyalkylene units. The total added amount by mole of alkylene oxide in a surfactant may be 1 or more, 3 or more, 5 or more, 10 or more, 15 or more, or 20 or more, and may also be 50 or less, 30 or less, 22 or less, 16 or less, 12 or less, 8 or less, or 4 or less (e.g., 3 or less).

A surfactant (e.g., an anionic surfactant) used in some embodiments has a hydrocarbon group. The hydrocarbon group may be formed of a saturated hydrocarbon(s) such as an alkyl group, or may include an unsaturated bond such as carbon-carbon double bond. The hydrocarbon group (typically, an alkyl group) may also be either linear or branched. The number of carbons atoms in the hydrocarbon group (e.g., an alkyl group) may be 8 or more, 10 or more, or 12 or more, and may also be 24 or less, 20 or less, 18 or less, 16 or less, or 12 or less. Particular examples of the hydrocarbon group (typically, an alkyl group) include an octyl group, a decyl group, a lauryl group, a myristyl group, a palmityl group, and a stearyl group.

The pH of the surfactant (pH of a surfactant with a concentration of 100% by weight, or pH of a surfactant available as a commercial product (that can contain an appropriate amount of water)) is not particularly limited, and is suitably, e.g., 5.0 or more, preferably 6.0 or more (e.g., more than 6.0), more preferably 6.5 or more, even more preferably 7.0 or more, and particularly preferably 7.5 or more (e.g., more than 8.0, and further 8.2 or more). The pH of the surfactant is suitably, e.g., less than 11.0, preferably less than 9.5, more preferably 9.0 or less (e.g., less than 9.0), and may be less than 8.0, less than 7.0, less than 6.0, or less than 5.0. Performing cleaning with use of a near-neutral surfactant facilitates achievement of high surface quality.

In addition, the pH of a liquid surfactant, cleaner, or the like (typically, a cleaning liquid) herein can be obtained by using a pH meter (e.g., a glass-electrode hydrogen ion concentration indicator manufactured by Horiba Ltd. (model: F-23)), calibrating at three points with use of standard buffers (a phthalate pH buffer, pH 4.01 (25°C), a neutral phosphate pH buffer, pH 6.86 (25°C), and a carbonate pH buffer, pH 10.01 (25°C)), then inserting a glass electrode in a cleaner to be measured, and measuring a value via stabilization after a lapse of 2 or more minutes.

The concentration of a surfactant in a cleaner is appropriately set within exerting an effect of presence of a surfactant, and is not limited to a certain range. The concentration of a surfactant in a cleaner can be 0.01 % or more by weight, and is suitably 0.1% or more by weight. In some embodiments, the concentration of a surfactant in a cleaner is 1% or more by weight, preferably 3% or more by weight, more preferably 10% or more by weight, and even more preferably 20% or more by weight, and may be 30% or more by weight or 40% or more by weight (e.g., 50% or more by weight). In such embodiment, the upper limit of the concentration of a surfactant in a cleaner can be less than 90% by weight, and may be less than 70% by weight, less than 50% by weight, or less than 35% by weight. Such a cleaner may take a form of a cleaning liquid containing a surfactant and water. In other some embodiments, the concentration of a surfactant in a cleaner can be approximately 90% or more by weight (e.g., 90-100% by weight), is appropriately 95% or more by weight, and may be 99% or more by weight. Such a cleaner may be substantially formed of a surfactant.

### (Water)

In some embodiments, a cleaner contains water in addition to a surfactant. A water-containing cleaner can allow a surfactant to exert more effect. Such a cleaner may be a cleaning liquid that is liquid at room temperature. Room temperature herein refers to 23°C. As water used in a cleaner, preferred are ion-exchanged water (deionized water), pure water, ultrapure water, distilled water, and the like. In addition, the cleaner disclosed herein may further contain an organic solvent (lower alcohol, lower ketone, etc.) that can be uniformly mixed with water, as necessary. Water preferably accounts for 90% or more by volume of a solvent in a cleaner, and more preferably accounts for 95% or more by volume (e.g., 99% to 100% by volume).

### (Optional Additive)

The cleaner disclosed herein may further contain one or two or more types of known additives that can be used in a cleaner, such as a chelator, a pH adjuster (an acidic or basic compound, etc.), an antioxidant, an antifoaming agent, an antiseptic agent, or an antifungal agent, as appropriate.

Examples of a chelator include aminocarboxylic acid-based chelators and organic phosphonic acid-based chelators. Examples of aminocarboxylic acid-based chelators include ethylenediamine tetraacetic acid, sodium ethylenediamine tetraacetate, nitorilotriacetic acid, sodium nitrilotriacetate, ammonium nitrilotriacetate, hydroxyethylethylenediamine triacetic acid, sodium hydroxyethylethylenediamine triacetate, diethylenetriamine pentaacetic acid, sodium diethylenetriamine pentaacetate, triethylenetetramine hexaacetic acid, and sodium triethylenetetramine hexaacetate. Examples of an organic phosphonic acid-based chelators include 2-aminoethyl phosphonic acid, I-hydroxyethylidene-1, 1-diphosphonic acid, aminotri(methylene phosphonic acid), ethylenediamine tetrakis(methylene phosphonic acid), diethylenetriamine penta(methylene phosphonic acid), ethane-1, 1-diphosphonic acid, ethane-1, 1, 2-triphosphonic acid, ethane-1-hydroxy-1, 1-diphosphonic acid, ethane-1-hydroxy-1, 1, 2-triphosphonic acid, ethane-1, 2-dicarboxylic-1, 2-diphosphonic acid, methane hydroxy phosphonic acid, 2-phosphonobuthane-1, 2-dicarboxylic acid, 1-phosphonobuthane-2, 3, 4-tricarboxylic acid, and α-methylphosphonosuccinic acid. Chelators can be used singly or in combination of two or more kinds.

The cleaner disclosed herein may not substantially contain a chelator. The phrase "a cleaner does not substantially contain a chelator" herein indicates that the concentration of a chelator in a cleaner is less than 1% by weight. The concentration of a chelator in a cleaner may be less than 0.3% by weight, less than 0.1% by weight, less than 0.01% by weight, or less than 0.005% by weight. The technologies disclosed herein can be preferably performed even in a mode where a cleaner does not contain a chelator.

The content of the optional additive described above can be in an appropriate range where an effect of the present invention is not significantly prevented. For example, the content of the optional additive in a cleaner is suitably less than 30% by weight, and may be less than 1 0% by weight, less than 1% by weight, less than 0.1% by weight, or less than 0.01% by weight. The technologies disclosed herein are preferably performed in a mode where a cleaner does not contain an optional additive. Of note, an optional additive is defined as a component different from a solvent such as water.

The usage of the optional additive described above can also be specified from a relation relative to a surfactant. In a cleaner, the content of an optional additive relative to 1 part by weight of a surfactant can be less than 3 parts by weight, and is suitably less than 1 part by weight. In view of suitably exerting an effect of presence of a surfactant, the content of an optional additive relative to 1 part by weight of a surfactant may be, e.g., less than 0.3 parts by weight, less than 0.1 parts by weight, less than 0.03 parts by weight, or less than 0.01 parts by weight. In view of exerting an effect of an additive, the content of an optional additive relative to 1 part by weight of a surfactant can be 0.00001 parts by weight or more, is suitably 0.001 parts by weight or more, and may be 0.1 parts by weight or more, 0.5 parts by weight or more, or 1 part by mass or weight.

In some embodiments, a cleaner (that may be a cleaning liquid) is substantially formed of a surfactant and water. Such a cleaner takes a form of a surfactant aqueous solution. In this embodiment, the total proportion of the surfactant and water in the cleaner is, e.g., 90% or more by weight (e.g., 90-100% by weight), preferably 95% or more by weight, and more preferably 99% or more by weight. Use of such a cleaner, substantially formed of a surfactant and water, tends to cause exertion of more effect of a surfactant.

### (pH)

The pH of the cleaner disclosed herein is not particularly limited. For example, the pH of the cleaner may be 0.5 or more, 1.0 or more, 2.0 or more, 3.0 or more, or 4.0 or more. In some preferable embodiments, the pH of the cleaner is suitably 5.0 or more, and preferably 6.0 or more (e.g., more than 6.0), and may be 6.5 or more, 7.0, 7.5 or more, or 8.0 or more. The pH of the cleaner may also be, e.g., 13.0 or less, 12.5 or less, 12.0 or less, or less than 12.0. In some embodiments, the pH of the cleaner is, e.g., less than 11.0, preferably less than 9.5, and more preferably 9.0 or less (e.g., less than 9.0), and may be less than 8.0, less than 7.0, less than 6.0, or less than 5.0. Performing cleaning with use of a near-neutral cleaner facilitates achievement of high surface quality.

### <Cleaning Method>

The cleaning method disclosed herein includes a step of cleaning a polished substrate formed of a high-hardness material using a cleaner (cleaning step). As the cleaner, the aforementioned cleaner is used. The cleaning method is not particularly limited, and can be performed with an appropriate means according to a purpose. For example, one or two or more cleaning processes can be selected and employed from cleaning by immersion, cleaning by spray injection, scrub cleaning, ultrasonic cleaning, and other cleanings. In view of cleanability, scrub cleaning is preferable. Herein scrub cleaning refers to cleaning by performing operation of wiping or scrubbing the surface of a substrate using a cleaning tool such as a sponge, a brush, or a non-woven fabric. For example, attachments such as particles attached to the surface of a substrate can be removed by applying a cleaner to the surface of a cleaning tool such as a sponge, a brush, or a non-woven fabric, and bringing the cleaning tool applied with the cleaner into contact with the surface of the substrate and then relatively moving the cleaning tool. The cleaning step is also preferably performed before drying of the surface of a polished substrate, in view of removability for attached particles. In addition, the cleaning step disclosed herein is preferably performed in a mode not including ultrasonic cleaning, microwave cleaning, or other cleaning.

In view of removability for attached particles, scrub cleaning with use of a sponge (e.g., polyvinyl alcohol (PVA) sponge) is preferable as a cleaning mean. Such cleaning is also referred to as sponge cleaning. Meanwhile, in the cleaning step (typically scrub cleaning), water (deionized water, pure water, ultrapure water, distilled water, etc.), an organic solvent (lower alcohol, lower ketone, etc.), or the like may or may not be additionally supplied on the surface of a substrate, as appropriate.

Duration of the cleaning step using a cleaner is not particularly limited, and is, in view of removability for particles on the surface of a substrate, suitably 10 seconds or more, preferably 30 seconds or more, and more preferably 1 minute or more. Moreover, in view of cleaning efficiency, the duration is suitably about 30 minutes or less, preferably 10 minutes or less, and more preferably 3 minutes or less (e.g., 1-2 minutes).

Temperature of a cleaner in the cleaning step can be usually normal temperature (typically 10°C or higher to lower than 40°C, e.g., about 20 to 30°C). The cleaner may be warmed (e.g., warmed to 40°C or higher or about 50°C to 80°C) to perform cleaning.

In some preferable embodiments, preliminary cleaning (also referred to as precleaning) is performed before the cleaning step using the cleaner. The preliminary cleaning is cleaning without use of the cleaner, and can employ one or two or more selected from e.g., cleaning by immersion, running water cleaning, cleaning by spray injection, scrub cleaning, and ultrasonic cleaning. For example, the preliminary cleaning may be immersion into water (deionized water, pure water, ultrapure water, distilled water, etc.; the same is applied hereinafter unless otherwise noted), running water cleaning, cleaning by spray injection of water, scrub cleaning with water, ultrasonic cleaning in a water chamber containing water, or the like. Immersion into water may be batch immersion by immersing a substrate into a water chamber containing water, overflow immersion performed with overflowing water from a water chamber, or quick dump immersion. In view of cleanability, scrub cleaning is preferable. Scrub cleaning with water is preferably performed with supplying water (running water) onto the surface of a substrate. As scrub cleaning in preliminary cleaning, scrub cleaning with use of a sponge (e.g., PVA sponge) is preferable. The preliminary cleaning step is preferably performed before drying the polished surface of a substrate in view of removability of attached particles, and the cleaning step is preferably performed before drying up of the surface of the substrate after the end of the preliminary cleaning step. In addition, the water described above may contain an appropriate amount of an organic solvent (lower alcohol, lower ketone, etc.)

Duration of the preliminary cleaning step is not particularly limited, and is, in view of cleanability, suitably 10 seconds or more, and preferably 30 seconds or more. Moreover, in view of cleaning efficiency, the duration is suitably about 10 minutes or less, and preferably 3 minutes or less (e.g., 1-2 minutes).

In some embodiments, post-cleaning is performed after the cleaning step with use of the cleaner described above. The post-cleaning can be performed in the same method as the preliminary cleaning described above except for being performed after the cleaning step, and duplicate illustration will be omitted. The post-cleaning may preferably employ a method with combination of running water cleaning and immersion cleaning (e.g., overflow immersion). When immersion cleaning is employed, duration of the post-cleaning step is suitably 1 minute or more, and preferably 10 minutes or more (e.g., about 10 to 30 minutes).

The cleaning method disclosed herein can achieve a good cleaning effect for a substrate formed of a high-hardness material, by using a surfactant, and further by scrub cleaning with use of a sponge in a preferable embodiment, and thus can be entirely preferably performed in a mode not including ultrasonic cleaning, microwave cleaning, or the like commonly used in conventional cleaning methods.

The surface roughness Ra of a substrate cleaned as described above is not particularly limited, and may be e.g., approximately 3 nm or less. The surface roughness Ra is preferably approximately 1 nm or less, more preferably approximately 0.3 nm or less, and more preferably less than 0.10 nm (e.g., about 0.01 to 0.07 nm). In addition, the Rmax of a cleaned substrate is not particularly limited, and preferably less than 30 nm, more preferably less than 20 nm, and even more preferably less than 10 nm. Performing cleaning with use of the cleaner disclosed herein offers a high-quality, clean surface as described above. The Ra and Rmax are measured using an atomic force microscope (AFM) as described later in the examples.

A cleaned substrate formed of a high-hardness material is forced to be dried using natural drying, a drying machine, etc., and then preferably used, e.g., as a semiconductor substrate material, in various device applications such as an optical devices and a power device.

### <Production Method of Substrate>

The specification also provides a production method of a substrate formed of a high-hardness material including the cleaning method described above. The production method of the substrate is a production method of, e.g., silicon carbide substrate. The technologies disclosed herein may include providing a production method of a substrate formed of a high-hardness material, and a substrate formed of a high-hardness material produced by the method. In other words, the technologies disclosed herein provide a production method of a substrate formed of a high-hardness material including a cleaning step that supplies any of the cleaners disclosed herein to a substrate formed of a high-hardness material and thereby cleans the substrate, and a substrate formed of a high-hardness material produced by the method. The production method may be performed by preferably applying contents of any of the cleaning methods disclosed herein. The production method may efficiently provide a substrate, such as a silicon carbide substrate, with improved surface quality and cleanness.

Furthermore, the production method of a substrate formed of a high-hardness material may include a step of polishing a substrate formed of a high-hardness material (polishing step), which is an object to be polished, before the cleaning step. The polishing step is particularly a step of polishing the surface of a substrate formed of a high-hardness material using the polishing composition described later. The cleaner and the cleaning method disclosed herein can suitably achieve a desired effect by being applied to a polished substrate formed of a high-hardness material experienced the polishing step described later. The cleaner and the cleaning method disclosed herein are preferably implemented in a mode with combination of the polishing described later. Accordingly, the specification provides a method of polishing and cleaning a substrate formed of a high-hardness material. Hereinafter description will be made for a polishing composition and a polishing method.

### <Polishing Composition>

### (Abrasive)

The polishing composition disclosed herein typically contains an abrasive. Presence of the abrasive in the polishing composition is preferable in view of efficiently achieving good smoothness. The species of the abrasive possibly including in the polishing composition is not particularly limited. For example, the abrasive may be any of inorganic particles, organic particles, and organic-inorganic composite particles. Examples include an abrasive substantially formed of any of oxide particles such as silica particles, alumina particles, cerium oxide particles, chromium oxide particles, titanium dioxide particles, zirconium oxide particles, magnesium oxide particles, manganese dioxide particles, zinc oxide particles, and iron oxide particles; nitride particles such as silicon nitride particles and boron nitride particles; carbide particles such as silicon carbide particles and boron carbide particles; carbonates such as calcium carbonate and barium carbonate. The abrasive can be used singly or in a combination of two or more kinds. In particular, oxide particles such as silica particles, alumina particles, cerium oxide particles, chromium oxide particles, zirconium oxide particles, manganese dioxide particles, and iron oxide particles can form a good surface and thus are preferable. In some embodiments, more preferable are alumina particles, zirconium oxide particles, chromium oxide particles, and iron oxide particles, and particularly preferable are alumina particles. In other some embodiments, even more preferable are silica particles, cerium oxide particles, and manganese dioxide particles, and particularly preferable are silica particles.

As used herein, with respect to the composition of the abrasive, "substantially consisting of X" or "substantially formed of X" means that the ratio of X in the abrasive (or the purity of X) is 90 % or more (preferably 95 % or more, more preferably 97 % or more, or yet more preferably 98 % or more, e.g. 99 % or more) on a weight basis.

In some embodiments, alumina particles are used as the abrasive. Alumina particles can be used singly or in combination of two or more kinds. When alumina particles are used as the abrasive, it is generally advantageous that alumina particles account for a high proportion in the total abrasives contained in the polishing composition. For example, the proportion of alumina particles in the total abrasives contained in the polishing composition is preferably 70% or more by weight, more preferably 90% or more by weight, and even more preferably 95% or more by weight (e.g., 95 to 100% by weight).

In some preferable embodiments, silica particles are used as the abrasive. Examples of the silica particles include colloidal silica, fumed silica and precipitated silica. In view of improving smoothness, the silica particles are preferably colloidal silica and fumed silica. In particular, colloidal silica is particularly preferable. The technologies disclosed herein are suitable for a method including polishing with use of a polishing composition containing silica particles. In polishing of a substrate using silica particles, when silica particles are attached to the surface of a substrate, it is often not easy to remove them compared to other particles. The technologies disclosed herein can preferably remove such silica particles attached to the surface of a substrate, using the cleaner described above. Silica particles can be used singly or in combination of two or more kinds.

When silica particles are used as the abrasive, it is generally advantageous that silica particles account for a high proportion in the total abrasives contained in the polishing composition. For example, the proportion of silica particles in the total abrasives contained in the polishing composition is preferably 70% or more by weight, more preferably 90% or more by weight, and even more preferably 95% or more by weight (e.g., 95 to 100% by weight).

Additionally, the polishing composition disclosed herein preferably uses a non-diamond abrasive containing substantially no diamond particle as the abrasive. Diamond particles have high hardness, and thus is potentially a limiting factor in improving smoothness. Diamond particles also have a high price in general, and thus is not necessarily a material advantageous in cost-effectiveness, and it is preferable to have less dependency on a high-price material such as diamond particles in practical view.

The average primary particle diameter of the abrasive (e.g., silica particles) is not particularly limited, and is 10 nm or more, more preferably 15 nm or more, and even more preferably 20 nm or more, and may be 50 nm or more or 60 nm or more, in view of improving polishing removal speed. Increase in the average primary particle diameter can achieve a higher polishing removal speed. Moreover, in view of surface quality after polishing, the average primary particle diameter is usually 500 nm or less, suitably 300 nm or less, preferably 150 nm or less, more preferably 100 nm or less, more preferably 80 nm or less, and e.g., 60 nm or less.

In the technologies disclosed herein, the average primary particle diameter of the abrasive refers to a particle diameter calculated from a specific surface area measured by BET (BET value), in accordance with the formula: average primary particle diameter (nm) = 6000/(true density (g/cm³) × BET value (m²/g)) (BET particle diameter). Measurement of a specific surface area can be made using e.g., a surface area measuring device having the product name of "Flow Sorb II 2300", manufactured by Micromeritics Instrument Corporation.

When the polishing composition contains an abrasive, the content of the abrasive in the polishing composition is usually suitably 0.01% or more by weight in view of polishing removal speed, and may be 0.1% or more by weight, 1% or more by weight, or 3% or more by weight. In view of efficiently improving smoothness, the content of the abrasive is preferably 10% or more by weight, and more preferably 20% or more by weight. Meanwhile, in view of providing good dispersibility, the content of the abrasive in a finishing polishing composition is usually suitably 50% or less by weight, and preferably 40% or less by weight, and may be 20% or less by weight, 10% or less by weight, or 8% or less by weight. In other some embodiments, the polishing composition may contain no abrasive in view of achieving a desired surface quality.

### (Polishing Auxiliary)

The polishing composition disclosed herein preferably contains a polishing auxiliary. The polishing auxiliary is a component that enhances a polishing effect, and a water-soluble one is typically used. The polishing auxiliary is not particularly construed with limitation, but is contemplated to contribute to polishing with an abrasive by acting to degenerate the surface of a substrate in polishing (typically, oxidative degeneration) to make the surface of a substrate fragile. For instance, with reference to silicon carbide (SiC) of a representative of high-hardness materials as an example, the polishing auxiliary in polishing might contribute to oxidation of SiC, i.e., conversion to SiOₓC_{y}. The SiOₓC_{y} has lower hardness than SiC monocrystal. Moreover, oxidation reaction can generally provide low hardness and fragility in a high-hardness material having a Vickers hardness of 1500 Hv or more. For these reasons, addition of the polishing auxiliary might improve polishing removal speed and surface quality of a substrate.

Examples of the polishing auxiliary include peroxides such as hydrogen peroxide; nitric acid compounds including nitric acid, salts thereof such as iron nitrate, silver nitrate, and aluminum nitrate, and complexes thereof such as ceric ammonium nitrate; persulfuric acid compounds including persulfuric acids such as potassium peroxomonosulfate and peroxodisulfuric acid, and salts thereof such as ammonium persulfate and potassium persulfate; chlorine compounds including chloric acid and salts thereof, and perchloric acid and salts thereof such as potassium perchlorate; bromine compounds including bromic acid and salts thereof such as potassium bromate; iodine compounds including iodic acid and salts thereof such as ammonium iodate, and periodic acid and salts thereof such as sodium periodate and potassium periodate; ferrates including ferric acid and salts thereof such as potassium ferrate; permanganates including permanganic acid and salts thereof such as sodium permanganate and potassium permanganate; chromates including chromic acid and salts thereof such as potassium chromate and potassium dichromate; vanadates including vanadic acid and salts thereof such as ammonium vanadate, sodium vanadate, and potassium vanadate; ruthenates including perruthenic acid and salts thereof; molybdates including molybdic acid and salts thereof such as ammonium molybdate and disodium molybdate; rhenates including perrhenic acid and salts thereof; and tungstates including tungstic acid and salts thereof such as disodium tungstate. These can be used singly or in an appropriate combination of two or more kinds. In some embodiments, preferable are permanganic acid or a salt thereof, chromic acid or a salt thereof, and ferric acid or a salt thereof, and particularly preferable are sodium permanganate and potassium permanganate. In other some embodiments, preferable are vanadic acid or a salt thereof, an iodine compound, molybdic acid and a salt thereof, and tungstic acid and a salt thereof, and particularly preferable are sodium metavanadate, sodium vanadate and potassium vanadate.

In some preferable embodiments, the polishing composition contains a composite metal oxide as the polishing auxiliary. Examples of the composite metal oxide include nitrate metal salts, ferric acids, permanganic acids, chromic acids, vanadic acids, ruthenic acids, molybdic acids, rhenium acids, and tungstic acids. In particular, more preferable are ferric acids, permanganic acids, chromic acids, vanadic acids, molybdic acids, and tungstic acids, and even more preferable are permanganic acids and vanadic acids.

The polishing composition disclosed herein may or may not further contain an oxidant other than the composite metal oxide. The technologies disclosed herein can be preferably performed in a mode where the composite metal oxide and an oxidant other than the composite metal oxide (e.g., hydrogen peroxide) are contained as oxidants. In addition, the technologies disclosed herein can be performed in a mode where a polishing auxiliary other than the composite metal oxide (e.g., hydrogen peroxide) is not substantially contained as the polishing auxiliary.

The content of the polishing auxiliary in the polishing composition is usually suitably 0.005 mol/L or more. In view of improving a polishing removal rate, the content of the polishing auxiliary in the polishing composition is preferably 0.008 mol/L or more, and more preferably 0.01 mol/L or more, and may be 0.03 mol/L or more, 0.05 mol/L or more, 0.06 mol/L or more, or 0.07 mol/L or more. In view of improving smoothness, the content of the polishing auxiliary in the polishing composition is usually suitably 0.5 mol/L or less, preferably 0.3 mol/L or less, and more preferably 0.2 mol/L or less, and may be 0.1 mol/L or less, or 0.09 mol/L or less.

### (Other Components)

The polishing composition disclosed herein may contain a known additive potentially used in a polishing composition (typically, a high-hardness material polishing composition such as a silicon carbide substrate polishing composition), such as a metallic salt, an alkali metal salt, an alkaline-earth metal salts, a chelator, a thickener, a dispersant, a pH adjuster, a surfactant, an inorganic polymer, an organic polymer, an organic acid, an organic acid salt, an inorganic acid, an inorganic acid salt, an antirust, an antiseptic, or an antifungal, as appropriate, unless it impairs an effect of the present invention. Since the content of the additive only has to be appropriately set according to the purpose of addition thereof and does not characterize the present invention, a detailed description thereof will be omitted.

### (Dispersion Medium)

A dispersion medium used for the polishing composition only has to be capable of dispersing the abrasive, and is not particularly limited. As the dispersion medium, ion-exchange water (deionized water), pure water, ultrapure water, distilled water, or the like can be preferably used. The polishing composition disclosed herein may further contain an organic solvent (lower alcohol, lower ketone, etc.) that can be uniformly mixed with water, as necessary. Usually, water preferably accounts for 90% or more by volume of the dispersion medium in the polishing composition, and more preferably accounts for 95% or more by volume (typically 99% to 100% by volume).

The pH of the polishing composition is not particularly limited. The pH of the polishing composition is usually suitably about 2 to 12. The pH of the polishing composition within the range facilitates achievement of a practical polishing removal rate. The pH of the polishing composition is preferably 2 to 10, and more preferably 3 to 9.5, and may be 4 to 8. In some embodiments, the pH of the polishing composition may be, e.g., 6 to 10, or may be 8.5 to 9.5.

A method for preparing the polishing composition disclosed herein is not particularly limited. For example, each component to be contained in the polishing composition may be mixed using a well-known mixing device such as a blade stirrer, an ultrasonic disperser, or a homo mixer. A mode for mixing these components is not particularly limited, and, for example, all components may be mixed at once or in an appropriately set order.

The polishing composition disclosed herein may be a single-agent type or a multi-agent type such as a two-agent type. For example, the polishing composition may be configured to be separately stored solution A that contains a part of components of the polishing composition, and solution B that contains the remaining components, and then be used as a mixture of solution A and solution B in polishing a substrate.

The polishing composition disclosed herein may take a concentrate form (i.e., a form of a concentrate liquid of a polishing slurry) before used for polishing. The polishing composition in such a concentrate form has advantage in view of convenience, cost reduction, etc., in manufacture, distribution, storage, or other processes.

### <Polishing Cleaning Set>

According to the description above, the specification provides a polishing cleaning set used in polishing and cleaning of a substrate formed of a high-hardness material. The polishing cleaning set includes a polishing composition and a cleaner. The polishing composition is used for polishing a substrate formed of a high-hardness material, and the cleaner is used for cleaning a polished substrate formed of a high-hardness material using the polishing composition. The polishing cleaning set is more particularly used in a production method of a substrate formed of a high-hardness material. As the polishing composition, the aforementioned polishing composition disclosed herein is used. As the cleaner, the aforementioned cleaner disclosed herein is used. In particular, the polishing composition may contain e.g., a polishing auxiliary. The polishing composition may also contain e.g., an abrasive (preferably a non-diamond abrasive). The cleaner also contains a surfactant. The polishing composition and the cleaner are typically mutually separated and stored. A substrate produced using the polishing cleaning set may have high surface quality after polishing, and obtain a clean surface via cleaning. Details of the polishing composition and the cleaner are as described above, and illustration thereof are omitted.

### <Polishing Method>

The polishing composition disclosed herein can be used for polishing a substrate in an exemplary mode including the following operations. That is, a polishing slurry (slurry) containing any of the polishing compositions disclosed herein is prepared. Preparing the polishing slurry can include adjusting the concentration of a polishing composition (e.g., diluting a polishing composition), preparing a polishing slurry by adjusting the pH of the polishing composition, and the like. Alternatively, the polishing composition described above may be directly used as a polishing slurry. In use of a multi-agent type polishing composition, preparation of the polishing slurry may include mixing the component agents thereof, diluting one or more of the agents before the mixing, diluting the resultant mixture after the mixing, and the like. Next, the polishing slurry is supplied to a polishing surface, and subjected to polishing by a common method performed by those skilled in the art. For example, such method is a method that sets a substrate in a common polishing machine and supplies the polishing slurry to a polishing surface of the substrate through a polishing pad of the polishing machine. Typically, while supplying the polishing slurry continuously, the polishing pad is pressed against the polishing surface of the substrate, and both of the surface and the pad are moved (e.g., rotated) relative to each other. Polishing of the substrate is completed through such a polishing step.

The specification provides a polishing method that polishes a substrate and a production method of a substrate that employs the polishing method. The polishing method is characterized by including a step of polishing a substrate using the polishing composition disclosed herein. A polishing method according to some preferred embodiments includes a step of performing preliminary polishing (preliminary polishing step) and a step of performing final polishing (final polishing step). In some preferred embodiments, the preliminary polishing step is a polishing step set immediately before the final polishing step. The preliminary polishing step may be a single-step polishing step or a polishing step including two or more sub-steps. The final polishing step as referred to herein designates a step of applying final polishing to a substrate that experienced preliminary polishing, specifically, a polishing step set at the end (i.e., on the most downstream) of polishing steps performed with a polishing slurry containing an abrasive. In such a polishing method including the preliminary polishing step and the final polishing step, the polishing composition disclosed herein may be used at a step in the preliminary polishing step, may be used in the final polishing step, or may be used in both of the preliminary polishing step and the final polishing step.

The preliminary polishing and the final polishing can be performed using both of a single-side polishing machine and a double-side polishing machine. In a single-side polishing machine, one side of an object to be polished is polished by attaching a substrate to a ceramic plate with wax, holding the substrate with a holder called a carrier, and then pressing a polishing pad against one side of the substrate and moving both relative to each other with supplying a polishing composition. This movement is, e.g., rotational movement. In a double-side polishing machine, both sides of a substrate are polished simultaneously by holding the substrate with a holder called a carrier, and then pressing polishing pads against opposing sides of the substrate and moving them relative to one another with supplying a polishing composition from above.

The polishing pad used in each polishing step disclosed herein is not particularly limited. For example, any of a non-woven fabric type, a suede type, and a hard foamed polyurethane type may be used. In some embodiments, non-woven fabric type polishing pads, hard-foamed polyurethane type polishing pads not containing an abrasive, and the like can be preferably employed.

A substrate polished by the method disclosed herein is typically cleaned after polishing. The cleaning step is a cleaning method disclosed herein (a cleaning method with use of a surfactant-containing cleaner).

The polishing method disclosed herein may include any other step in addition to the preliminary polishing step and final polishing step described above. Examples of such a step include a mechanical polishing step, a lapping step, and the like performed before the preliminary polishing step. In the mechanical polishing step, a substrate is polished with a liquid of diamond abrasives dispersed in a solvent. In some preferred embodiments, the dispersion contains no oxidant. The lapping step is a step of polishing with pressing a surface of a polishing platen, such as a cast iron platen, to a substrate. Therefore, in the lapping step, no polishing pad is used. The lapping step is typically performed by supplying abrasives between a polishing platen and a substrate. The abrasives are typically diamond abrasives. In addition, the polishing method disclosed herein may include an additional step before the preliminary polishing step or between the preliminary polishing step and the final polishing step.

### [Examples]

Several working examples related to the present invention will be described below, but the present invention is not limited to these examples. In the following description, "%" is on a weight basis unless otherwise specified.

### <Comparative Example 1>

### [Polishing Test]

### (Preparation of Polishing Composition)

Colloidal silica as an abrasive, hydrogen peroxide and vanadates as polishing auxiliaries, and deionized water were mixed to prepare a polishing slurry. The colloidal silica used had an average primary particle diameter of about 80 nm. The content of the abrasive in the polishing slurry was 23%.

### (Polishing Conditions)

A SiC wafer was prepared by performing lapping beforehand with use of diamond abrasives having an average particle diameter of 5 µm, and further performing preliminary polishing beforehand with use of a polishing slurry containing alumina abrasives (particles).

Using the polishing slurry thus prepared, the surface of the preliminarily polished SiC wafer was polished according to the following polishing conditions.
Polishing machine: single-side polishing machine manufactured by Fujikoshi Machinery Corp., model "RDP-500"
Polishing pad: "SUBA800", manufactured by Nitta Haas Incorporated.
Polishing Pressure: 300 g/cm².
Platen rotational speed: 80 revolutions/min.
Head rotational speed: 40 revolutions/min.
Flow rate of slurry: 20 mL/min (one-way).
Slurry Temperature: 25°C.
Substrate: SiC wafer (conduction type: n-type, crystalline type: 4H-SiC, off angle to the C-axis of the main surface (0001): 4°), 2 inches.
Polishing time: 1 min.

### [Cleaning Test]

The polished SiC wafer was removed from the polishing machine, transferred to a clean room, and subjected to scrub cleaning with running water (pure water) using a commercially available PVA (polyvinyl alcohol) sponge for 1 minute under a room temperature environment, followed by cleaning with running water (pure water) for 1 minute. Furthermore, cleaning was performed with running water (pure water) for 15 minutes or more (overflow immersion).

### [AFM Observation]

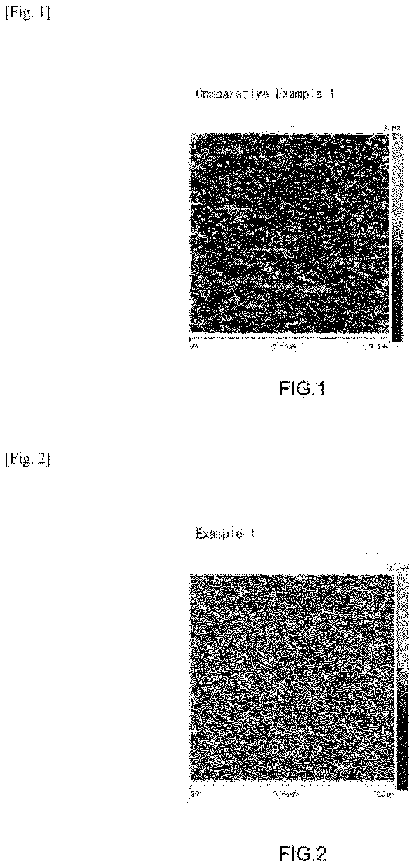

The surface (C face) of a SiC wafer naturally-dried in a clean room over night was observed for 10 µm × 10 µm areas of three locations using an atomic force microscope (AFM; manufactured by Bruker Corporation, device model: Nano Scope V), and attachment of particles was confirmed over the face. Fig. 1 shows an AFM image of the surface of a cleaned SiC wafer according to Comparative Example 1.

### <Example 1>

### [Polishing Test]

Polishing test was performed in the same method and conditions as Comparative Example 1.

### [Cleaning Test]

### (Preparation of Cleaning Liquid)

A cleaning liquid was obtained by diluting sodium polyoxyethylene laurylether sulfate (the added amount of ethyleneoxide by mole: 3 in average, the number of carbons in an alkyl group: 12 to 14, an aqueous solution with a concentration of 27%, pH of an undiluted liquid: 8.6) as a surfactant A 5 times with water (pure water).

### (Cleaning)

The polished SiC wafer was removed from the polishing machine, transferred to a clean room, and subjected to scrub cleaning with running water (pure water) using a commercially available PVA sponge for 1 minute under a room temperature environment. Then, the wafer was immersed into the cleaning liquid prepared as described above and subjected to ultrasonic cleaning for 1 minute. Subsequently, cleaning was performed with running water (pure water) for 1 minute. Furthermore, cleaning was performed with running water (pure water) for 15 minutes or more (overflow immersion).

### [AFM Observation]

AFM observation for the surface (C face) of the cleaned SiC wafer in the same method as Comparative Example 1 confirmed a small amount of particles attached onto the surface, but the amount of the attachment of the particles was clearly smaller than that of Comparative Example 1. In addition, the same was true on an Si face. Fig. 2 shows an AFM image of the surface of a cleaned SiC wafer according to Example 1.

### <Example 2>

### [Polishing Test]

Polishing test was performed in the same method and conditions as Comparative Example 1.

### [Cleaning Test]

### (Preparation of Cleaning Liquid)

Sodium polyoxyethylene laurylether sulfate (the added amount of ethyleneoxide by mole: 3 in average, the number of carbons in an alkyl group: 12 to 14, an aqueous solution with a concentration of 27%, pH of an undiluted liquid: 8.6) was prepared as a surfactant A and used as a cleaner.

### (Cleaning)

The polished SiC wafer was removed from the polishing machine, transferred to a clean room, and subjected to scrub cleaning with running water (pure water) using a commercially available PVA sponge for 1 minute under a room temperature environment. The wafer was subject to scrub cleaning for 1 minute using a PVA sponge applied with the cleaner thus prepared. Then, cleaning was performed with running water (pure water) for 1 minute, and further cleaning (overflow immersion) was performed with running water (pure water) for 15 minutes or more.

### [AFM Observation]

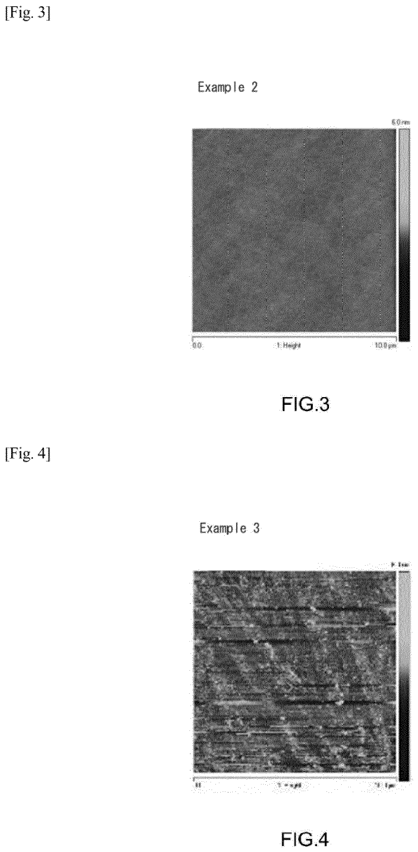

AFM observation for the surface (C face) of the cleaned SiC wafer in the same method as Comparative Example 1 confirmed no particle attached onto the surface, and also displayed no other attachment. In addition, the same was true on an Si face. Fig. 3 shows an AFM image of the surface of a cleaned SiC wafer according to Example 2. As measured using the AFM, the surface of the cleaned SiC wafer (C face) had a Ra of 0.0497 nm and a Rmax of 8.54 nm.

### <Example 3>

### [Polishing Test]

Polishing test was performed in the same method and conditions as Comparative Example 1.

### [Cleaning Test]

Polyoxyethylenealkylether (the added amount of ethyleneoxide by mole: 9, alkyl group: isotridecyl group (13 carbons)) was prepared as a surfactant B and used as a cleaner. This cleaner had a pH of 6.6. Cleaning was performed in the same manner as Example 2 except for using this cleaner.

### [AFM Observation]

AFM observation for the surface (C face) of the cleaned SiC wafer in the same method as Comparative Example 1 confirmed particles attached onto the surface, but the amount of the attachment of the particles was clearly smaller than that of Comparative Example 1. Attachments other than particles were also found. In addition, an Si face was also found to have a small amount of attached particles, and further, attachments other than the particles. Fig. 4 shows an AFM image of the surface of a cleaned SiC wafer according to Example 3.

### <Example 4>

### [Polishing Test]

Polishing test was performed in the same method and conditions as Comparative Example 1.

### [Cleaning Test]

Alkyltrimethyl ammonium chloride (alkyl group: hexadecyl group, stearyl group (16 to 18 carbons)) was used as surfactant C to provide an aqueous solution containing the surfactant in a concentration of 28%. This was used as a cleaner. The cleaner had a pH of 7.1. Cleaning was performed in the same manner as Example 2 except for using this cleaner.

### [AFM Observation]

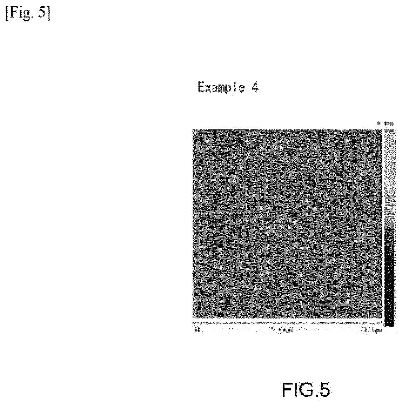

AFM observation for the surface (C face) of the cleaned SiC wafer in the same method as Comparative Example 1 confirmed a small amount of particles attached onto the surface, but the amount of the attachment of the particles was clearly smaller than that of Comparative Example 1. In addition, no particle was attached onto an Si face. Fig. 5 shows an AFM image of the surface of a cleaned SiC wafer according to Example 4.

The results of Examples 1 to 4 and Comparative Example 1 are summarized in Table 1. In Table 1, exerting the best cleanability is represented by "+++", exhibiting good cleanability is represented "++", displaying a certain cleaning effect is represented by "+", no cleaning effect is represented by "-".

### [Table 1]

**Table 1**

| | Cleaner | Method | Cleanability |
|---|---|---|---|
| Example 1 | surfactant A | imersion | ++ |
| Example 2 | surfactant A | scrub | +++ |
| Example 3 | surfactant B | scrub | + |
| Example 4 | surfactant C | scrub | ++ |
| Comparative Example 1 | pure water | scrub | - |

The experimental results described above confirmed that a cleaner contained a surfactant has a cleaning effect for a polished SiC wafer.

Particular examples of the present invention have been described in detail so far, but these are solely illustrations and do not limit the claims. The technologies recited in the claims encompass various modifications and changes of the examples illustrated so far.

## Claims

1. A method of polishing and cleaning a substrate formed of a material having a Vickers hardness of 1500 Hv or more, the method comprising:
polishing a substrate to be polished using a polishing composition; and
cleaning the polished substrate using a cleaner;
wherein the polishing composition comprises a polishing auxiliary and the cleaner comprises a surfactant.

2. The method according to claim 1, wherein the cleaner comprises an anionic surfactant as the surfactant.

3. The method according to claim 1 or 2, wherein the surfactant is a compound having an oxyalkylene unit.

4. The method according to any one of claims 1 to 3, wherein the surfactant in the cleaner has a concentration of 1% or more by weight.

5. The method according to any one of claims 1 to 4, wherein the cleaner further comprises water.

6. The method according to any one of claims 1 to 5, wherein the polishing composition comprises a non-diamond abrasive.

7. The method according to any one of claims 1 to 6, wherein the substrate formed of the material having a Vickers hardness of 1500 Hv or more is a silicon carbide substrate.

8. A cleaner used in the method according to any one of claims 1 to 7, the cleaner comprising a surfactant.

9. A polishing cleaning set used in the method according to any one of claims 1 to 7, comprising:
a polishing composition and a cleaner,
wherein the polishing composition comprises a non-diamond abrasive, or a polishing auxiliary or both, and
wherein the cleaner comprises a surfactant.

10. A cleaning method for a silicon carbide substrate after polishing with use of a non-diamond abrasive, or a polishing auxiliary or both, the cleaning method comprising:
cleaning the silicon carbide substrate using a cleaner,
wherein the cleaner comprises a surfactant.

11. A cleaner used in cleaning of a silicon carbide substrate after polishing with use of a non-diamond abrasive, or a polishing auxiliary or both, wherein the cleaner comprises a surfactant.
